(19)

Europäisches
Patentamt

European
Patent Office

Office européen
des brevets

(11) **EP 3 382 826 A1**

(12) **EUROPEAN PATENT APPLICATION**

(43) Date of publication:
03.10.2018 Bulletin 2018/40

(51) Int Cl.:
**H01S 3/00** *(2006.01)*    *H05G 2/00 (2006.01)*
**H01S 3/11** *(2006.01)*

(21) Application number: **17163851.3**

(22) Date of filing: **30.03.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **GSI Helmholtzzentrum für
Schwerionenforschung GmbH
64291 Darmstadt (DE)**

(72) Inventors:
• **Rykovanov, Sergey
07743 Jena (DE)**
• **Seipt, Daniel
01097 Dresden (DE)**

(54) **METHOD AND DEVICE FOR CREATING A PHASE MODULATED ULTRASHORT LASER PULSE**

(57)    The invention describes a method and a device for creating a phase modulated ultrashort laser pulse (12), comprising the following steps:
- an initial ultrashort laser pulse (1) is split into a first laser pulse (3) and a second laser pulse (6),
- a time delay ($\delta$) is introduced between the first and the second laser pulse (3, 6),
- a positive chirp is applied to the first laser pulse (3) and a negative chirp is applied to the second laser pulse (6) obtaining an instantaneous frequency ($\omega_L(t)$) for the first and second laser pulse (3) and (6), and
- the first laser pulse (3) and the second laser pulse (6) are recombined to form the phase modulated ultrashort laser pulse (12).

The method and device can be used for Compton scattering of accelerated electrons with the phase modulated ultrashort laser pulses.

Fig. 3a

## Description

The current invention is directed to a method and device for creating a phase modulated ultrashort laser pulse, wherein the phase modulated ultrashort laser pulse may preferably be used for an interaction with charged particles, such as an electron, for example in a laser pulse-electron-scattering. The phase modulated ultrashort laser pulse may be used for generating high energy photons.

Due to their high electric field amplitude and short duration, ultrashort laser pulses have many applications ranging from information technology to material processing. Examples include femtochemistry, tissue engineering, surgery and direct laser writing. In particular, ultrashort laser pulses are widely used in interaction with charged particles, such as electrons or ions.

The interaction of charged particles with laser light is mainly characterized by the interaction of the electric field of the laser with the electric charge of the particles. Following the oscillations of the electric field, the particles are accelerated and decelerated. For a sine or cosine wave with constant amplitude, the charged particle feels constant laser pressure, leading to an on average constant longitudinal drift of the particle.

For laser pulses, however, the oscillating electric field becomes inhomogeneous, since the amplitude of the electric field follows the time-dependent intensity envelope of the laser pulse. For such an inhomogeneous oscillating electric field, a so called ponderomotive force is observed. The ponderomotive force accelerates free charged particles towards the weak field regime of the laser pulse, which is referred to as ponderomotive effect. As the ponderomotive force depends on the amplitude of the (time-dependent) electric field of the laser pulse, it becomes highly important for ultrashort laser pulses having high electric field amplitudes.

One example, in which ultrashort laser pulses are applied and the ponderomotive force plays an important role, concerns the generation of x- or gamma-ray photons using Compton scattering.

Compton scattering is a well-established source for x- and gamma-ray and is based on inelastic scattering of a photon by a charged particle, usually an electron. Normally, Compton scattering results in an energy transfer from the photon to the electron and the scattered photon exhibits a lower energy and thus a lower frequency.

In order to generate x- and gamma-radiation, a process called inverse Compton scattering (or Thomson scattering) may be utilized. For inverse Compton scattering, high-energy electrons interact with incident photons and the resulting energy transfer from the electrons generates photons with higher energies and frequencies. Usually, relativistic electron beams, i.e. electrons with a speed close to the speed of light, are used for this purpose and may be provided by appropriate electron accelerators, such as electron linacs or laser- plasma accelerators. Compared to other methods for x- and gamma-ray generation, e.g. using bremsstrahlung, Compton scattering allows generation of a relatively narrow spectrum. In principle, Compton scattering promises a compact, tunable, spectrally narrow, pulsed and intensive radiation source for various applications ranging from material science and medical applications to fundamental research of atomic nuclei.

However, current Compton scattering sources cannot provide all of the properties mentioned above. The reasons will be explained in more detail in the following.

In general, the cross section of the Compton scattering process is relatively low. Thus, the total photon yield for the x-ray or gamma-ray generation is quite low. Therefore, the most straightforward approach is to increase the density of photons in the laser pulse and thus to increase the laser pulse intensity, e.g. by having a harder focusing point and/or higher laser pulse energy.

Higher laser pulse intensities, however, result in a stronger ponderomotive force, and so called ponderomotive broadening of the obtained x- and gamma-ray spectrum is observed. Due to the ponderomotive force, the electrons are slowed down at the peak of the laser pulse, and the corresponding scattered photons exhibit a lower frequency compared to the photons scattered at the low intensity wings of the laser pulse. Therefore, the photons generated near the peak of the pulse are relatively red-shifted, i.e. exhibit a lower frequency, compared to photons for which the ponderomotive force will be lower or may even be neglected. In consequence, the radiation generated by the Compton scattering is not as narrow banded as desired due to the high intensity of the laser pulse. In other words, the scattered photons do not show a single frequency, but a broad frequency spectrum.

The effects outlined above are described in more detail in "Beam-shape effects in nonlinear Compton and Thomson scattering" published in Physical Review A 81, 022125 (2010). In order to limit the red shift and the generation of higher harmonics, it is proposed to limit focusing and thus the laser pulse intensity at the interaction point with the electrons. However, this also limits the intensity of the Compton scattering spectrum, since only a limited amount of x- and gamma-radiation is generated.

"Quasi-monoenergetic femtosecond photon sources from Thomson Scattering using laser plasma accelerators and plasma channels" published in J. Phys. B: At. Mol. Opt. Phys. 47 (2014) 234013 discusses methods for improving the radiation source via laser waveguides or plasma channels. The proposed plasma channel increases the photon flux and thus allows reducing the required laser energy.

"Narrowband inverse Compton scattering x-ray sources at high laser intensities" published in Physical Review A 91, 033402 (2015) studies the ponderomotive broadening of the spectrum in Compton scattering of laser pulses on relativistic electrons. The frequency $\omega_\gamma$ of the scattered photon is proportional to the term

$$\omega_\gamma \propto \frac{\omega_L}{1 + I(t)}$$

with $\omega_L$ being the laser frequency and $I(t)$ being the time-dependent intensity amplitude of the laser pulse.

To compensate for the time-dependent amplitude of the laser pulse, it was proposed to use a temporal laser pulse chirping to compensate the spectrum broadening of the frequency $\omega_\gamma$ of the scattered photon. In this case, an instantaneous (i.e. time-dependent) laser frequency $\omega_L(t)$ would be provided such that it compensates for the broadening of the frequency spectrum. This, however, is a theoretical approach only as realizing such a non-linear temporal chirp in experimental system is reliably not possible with optical paths according to the stand of the art. Methods for generation of compensating chirped laser pulses are not disclosed in the literature.

It is, therefore, an object of the present invention to provide a method and a device for creating laser pulses compensating the frequency broadening in the frequency of the scattered photons in an electron-laser light scattering (Compton scattering). In a further aspect, it is an object of the invention to provide a method and a device for creating a laser pulse compensating ponderomotive effects, in particular ponderomotive broadening observed in Compton scattering.

This object is solved by the method with the feature of claim 1 and the device with the features of claim 10.

Specifically, the method for creating a phase modulated ultrashort laser pulse comprises splitting an initial ultrashort laser pulse into a first and second laser pulse. After splitting the initial ultrashort laser pulse into a first and second laser pulse in a suited beam splitter, such as a 50/50 split mirror, the first and second laser pulse have basically the same duration as the initial ultrashort laser pulse.

An ultrashort (also called: ultrafast) laser pulse typically has a pulse duration of less than a few picoseconds. The invention preferably relates to laser pulses with a pulse duration in the range of a few optical cycles or less than 100 femtoseconds. Such ultrashort laser pulses show some physical properties usually not associated with laser radiation. Due to their short duration, ultrashort laser pulses are not monochromatic, but exhibit a broadened spectrum $\Delta\omega_L$ comprising a plurality of frequencies $\omega_L$ around a central frequency $\omega_{L,0}$ (corresponding to the central wavelength $\lambda_{L,0}$). For example, an ultrashort laser pulse with duration on the order of 50 femtoseconds with a central wavelength of about $\lambda_{L,0}$ = 800 *nm* typically has a spectral bandwidth of about $\Delta\lambda_L$ = 40 *nm*.

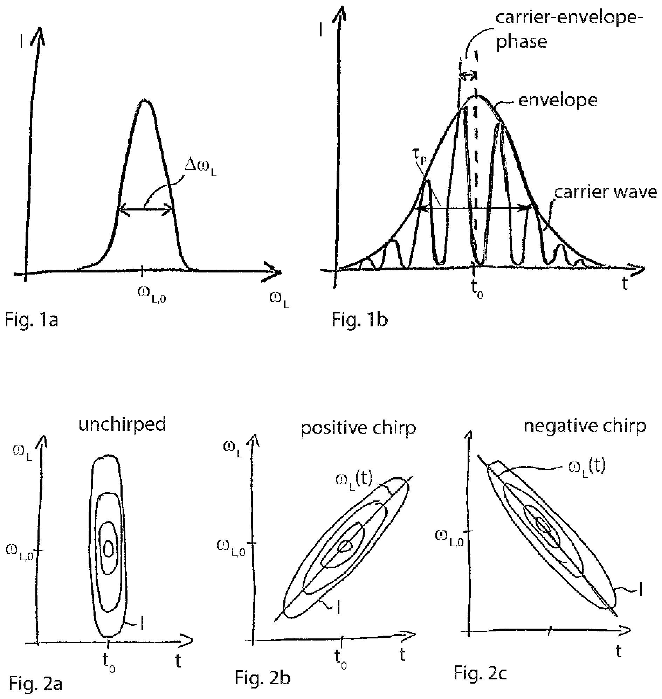

This is illustrated in the schematic Figure 1. Figure 1b shows the intensity / amplitude of the ultrashort laser pulse as a function of time. The spectral distribution or amplitude around the central frequency $\omega_{L,0}$ is shown in Figure 1a as a function of the frequency $\omega_L$. A permanent or continuous wave (cw) laser would emit a monochromatic laser light with the frequency $\omega_{L,0}$. The spectrum of the laser light of the ultrashort laser pulse is broadened and has the frequency bandwidth $\Delta\omega_L$. The envelope of the distribution thus comprises a plurality of frequencies not indicated in the picture of Fig. 1 a.

After splitting the initial ultrashort laser pulse into separate first and second laser pulses, a time delay is introduced between the first and the second laser pulses such that the first pulse is arranged earlier in time than the second pulse. Preferably, the time delay is chosen such that the first and second lasers pulses are still overlapping partially in time.

Further, a positive chirp is applied to the first laser pulse and a negative chirp is applied to the second laser pulse.

The technique of applying a chirp to ultrashort laser pulses is known in the art. By use of optical elements, such as gratings or prisms, the light of the laser pulse can spatially be separated into its different spectral components, and the different spectral components can be arranged sequentially in time. In an ascending (positive) chirp, the frequency $\omega_L$ is increasing with time, and in a descending (negative) chirp, the frequency $\omega_L$ is decreasing with time.

One can illustrate this technique of applying a chirp to ultrashort laser pulses in a musical picture. The unchirped laser pulse may be understood as a chord, in which several frequencies (i.e. tones) are played together. Just as the tones of a chord may be played at the same time or subsequently in an ascending (higher tones later) or descending (lower tones later) time sequence, the frequencies of an ultrashort laser pulse may be emitted in the shortest time possible (i.e. together) or may be arranged sequentially in time. Following this musical picture, a sequential arrangement of different frequencies in time is referred to as "chirp". An increase of the frequency with time is called up-chirp or positive chirp, whereas a decrease of frequency with time is called down-chirp or negative chirp.

The influence of chirping is schematically illustrated in Figure 2 showing three-dimensional plots of the intensity $I$ (z-axis) as a function of time t (x-axis) and frequency $\omega_L$ (y-axis). The intensity (z-axis) is represented by closed dashed curves, wherein the inner closed curves indicate a higher intensity (similar to a contour map).

Figure 2a shows the frequency-time distribution of an unchirped ultrashort laser pulse. In this case, all frequencies $\omega_L$ are emitted basically at the same time $t_0$. Figure 2b shows the frequency-time distribution of an ultrashort laser pulse with positive chirp (i.e. increase of the frequency $\omega_L$ with time t). Fig. 2c shows the frequency-time distribution of an ultrashort laser pulse with negative chirp (i.e. decrease of the frequency $\omega_L$ with time t). The frequency-time dependence of the frequency $\omega_L$ as a function of time around the central frequency $\omega_{L,0}$ is designated as instantaneous frequency $\omega_L(t)$. This instantaneous frequency $\omega_L(t)$ is shown as line in the Figures 2b and 2c, showing an increasing instantaneous frequency (i.e. a positive chirp) and a decreasing instantaneous frequency (i.e. a negative chirp), respectively.

As evident form a comparison of Figure 2a with Figures 2b or 2c, chirping of an initially unchirped laser pulse increases its pulse duration, and therefore decreases its peak intensity, and with the decrease of the peak intensity also decreases the ponderomotive spectrum broadening of the spectrum of the scattered photons. Accordingly, by chirping the first and second laser pulse, the duration of the first and second laser pulse are increased. When referring to the duration $\tau_P$ of the first and second laser pulse, the duration of the first and second chirped laser pulse are meant.

Summarizing the previous method steps, an ultrashort laser pulse is split into a first laser pulse and a second laser pulse. A time delay is introduced between the first and second laser pulse, and a positive chirp is applied to the first laser pulse and a negative chirp is applied to the second laser pulse. Applying a chirp to the first and second laser pulses leads to an instantaneous frequency $\omega_L(t)$. The term "instantaneous frequency" in particular means, that a mean or peak value of the frequency distribution shows a time dependency (or in other words varies with time). Accordingly, the instantaneous frequency $\omega_L(t)$ is a time dependent frequency.

In other words, the first and second laser pulses are phase modulated by adding a spectral phase $\tilde{\Phi}(\omega)$ to each of the first and second laser pulses comprising the time delay and the amount of (positive and negative) chirp, respectively.

The time delay of the first and second laser pulses may be regulated in line with the invention by adjusting the relative optical path lengths of the first and second laser pulses. The travelling time of the first and second laser pulse (propagating with the speed of light each) depends on their respective path length until their recombination. Accordingly, by relatively adjusting the path length of first and second laser pulse in the setup of the optical components, the delay between the first and second laser pulse can be regulated.

The application of the positive and negative chirp can be achieved by using, for example, acousto-optical dispersive filter or diffraction gratings. This is a known technique with an easy to handle experimental setup.

Finally, both the first laser pulse and the second laser pulse are (preferably coherently) recombined to form the phase modulated ultrashort laser pulse.

Throughout this application, the terms "(initial) ultrashort laser pulse", "first laser pulse", "second laser pulse" and "phase modulated ultrashort laser pulse" are used to designate the respective laser pulses as obtained by the different process steps defined above and should not be understood as generic terms. Thus, the term "first or second laser pulse" refers to the one of the two laser pulses obtained by splitting the single initial ultrashort laser pulse into two pulses. In a similar manner, the term "phase modulated ultrashort laser pulse" (also referred to as "two-pulse") refers to the laser pulse obtained by coherent recombination of the first and second laser pulses. In contrast, the first laser pulse is not designated as "phase modulated ultrashort laser pulse" though after chirping the first laser pulse is also phase modulated.

The resulting pulse shape of the phase modulated ultrashort laser pulse is characterized by an initially increasing instantaneous frequency (i.e. a positive chirp) until the intensity of the second laser pulse exceeds the intensity of the first laser pulse. Then the intensity of the negatively chirped second laser pulse is larger compared to the intensity of the first laser pulse, and the instantaneous frequency the phase modulated ultrashort laser pulse decreases (i.e. a negative chirp). With the current invention, each frequency (apart from the maximum instantaneous frequency) of the phase modulated ultrashort laser pulse will be present at two different points in time. Such a pulse shape is not possible by conventional pulse shaping techniques.

It was found by way of simulation of the physical processes proposed with the invention that a resulting pulse shape of the modulated ultrashort laser pulse (two-pulse) compensates the spectrum broadening of the frequency $\omega_\gamma$ of the scattered photon due to the ponderomotive effect described before for Compton scattering photon sources, without using chirping in the temporal domain, i.e. by modulating the instantaneous laser frequency as a function of time. Such chirping in the temporal domain is difficult to realize in an experimental setup with the required precision. Instead it is proposed to simply create a so called "two-pulse" as phase modulated ultrashort laser pulse used for scattering with high energy electrons in Compton scattering. This two-pulse can be created in a simple experimental setup with the method steps as described before. The time dependence of the instantaneous frequency $\omega_L(t)$ narrows the spectral bandwidth $\Delta\omega_\gamma$ of the photon scattered in Compton scattering, according to

$$\omega_\gamma \propto \frac{\omega_L(t)}{1 + I(t)} \approx const.$$

The blue-shifted laser frequency at the peak of the two-pulse compensates the intensity dependent ponderomotive red-shift. In an acoustic example, it is like adjusting the pitch of the siren of an emergency vehicle such that the Doppler-shifted frequency you hear as an observer does not change as the vehicle passes.

According to a preferred embodiment, linear chirping may be applied to the first and second laser pulse. Linear chirping means that time dependence of the instantaneous frequency $\omega_L(t)$ is a linear function as shown in Figures 2b and 2c. Figure 2b shows a positive linear dependency, and Figure 2c shows a negative linear dependency. Linear chirp can be handled easily in an experimental setup. Accordingly, linear chirps are preferred, since realization and optimization of non-linear chirps is experimentally more difficult. Further, optimization of the laser pulse parameters for the first, second and phase modulated ultrashort laser pulses is more difficult for non-linear chirps, since higher order terms of the spectral phase had to be considered.

The amount of linear chirping can be quantified by the slope of the line describing the instantaneous frequency $\omega_L(t)$. Opposite chirp means that the amount of chirp of the positive and the negative chirp is the same (in the sense of identical or at least similar or roughly the same). This means in case of linear chirp, that the slopes $d\omega_L/dt$ of the lines describing the instantaneous frequency may simply have opposite signs.

In a more general case, it is preferred according to the invention that the positive chirp of the first laser pulse and the negative chirp of the second laser pulse are opposite to each other, i.e. show the same (in the sense identical or at least similar or roughly the same) amount in their time dependence with different signs. Roughly the same amount of positive and negative chirp more generally means that the positive chirp of the first laser pulse corresponds to 80% to 120%, preferably 90% to 110%, mostly preferred 100% $\pm$ 5%, of the absolute value of the negative chirp of the second laser pulse and/or that the negative chirp of the second laser pulse corresponds to 80% to 120%, preferably 90% to 110%, mostly preferred 100% $\pm$ 5%, of the absolute value of the positive chirp of the first laser pulse. Mostly preferred, the absolute value of the positive chirp of the first laser pulse and the negative chirp of the second laser pulse are basically the same, e.g. differ by less than 5%.

Opposite chirp of the two pulses leads to a symmetric form of the envelope (pulse shape) of the two-pulse. A further consequence is that the pulse duration $\tau_P$ of the chirped first and second pulses is the same.

Irrespective of choosing opposite chirp or different chirp functions for the first and second laser pulse, it may be preferred that the first and second laser pulse have the same (in the sense of an identical or at least similar or roughly the same) pulse duration $\tau_P$. The pulse duration can for example be defined as the full width of the distribution at the $1/e$-value of its full amplitude. The same (in the sense of an at least similar) pulse duration $\tau_P$ also enhances a symmetric pulse shape of the two-pulse which was found to reduce the ponderomotive spectrum broadening of electrons scattered with the phase modulated ultrashort laser pulse (two-pulse). The same pulse duration more generally means that the pulse duration of the first laser pulse is between 80% to 120%, preferably 90% to 110%, mostly preferred 100% $\pm$ 5% of the pulse duration of the second laser pulse and vice versa.

Advantageously, the time delay $\delta$ between the first laser pulse and the second laser pulse is the same as the pulse duration $\tau_P$ of the first and second laser pulse (being assumed to be the same in the sense described before). This leads to a shape (envelope) of the two-pulse following roughly a Gaussian shape. Further, the maximum frequency ($\omega_{max}$) (instantaneous frequency) of the two-pulse coincides with the maximum amplitude of the two-pulse. The feature that the time delay $\delta$ and the pulse duration $\tau_P$ of the first and second laser pulse are the same generally means that the delay between the first laser pulse and the second laser pulse is 60% to 140%, preferably 80% to 120%, more preferably 100% $\pm$ 10%, of the pulse duration of the first and second laser pulse. Within these ranges, the pulse duration of the phase modulated ultrashort laser pulse is kept as short as possible and the phase modulation of the phase modulated ultrashort laser pulse can be close to predicted optimal values.

In case that the pulse durations $\tau_P$ of the first and second laser pulse are different, the time delay $\delta$ between the first laser pulse and the second laser pulse may be chosen as the mean value of the time pulse durations $\tau_P$ of the first and second laser pulse.

Regarding use of the phase modulated ultrashort laser pulse for Compton scattering of electrons, it may be preferred that the pulse duration of the initial ultrashort laser pulse is between 5 and 20 femtoseconds. In general, the best results can be achieved with the shortest laser pulses having the broadest spectral bandwidth. With shorter pulses, the amplitude of the phase modulated ultrashort laser pulse will be higher and interaction with charged particles having low cross sections, such as Compton scattering, will be enhanced.

The intensity of the initial ultrashort laser pulse may be in line with the proposed invention less than $100 \cdot 1.37 \cdot 10^{18}$ W/cm$^2$, preferably between $0.25 \cdot 1.37 \cdot 10^{18}$ W/cm$^2$ and $20 \cdot 1.37 \cdot 10^{18}$ W/cm$^2$, mostly preferred between $1 \cdot 1.37 \cdot 10^{18}$ W/cm$^2$ and $16 \cdot 1.37 \cdot 10^{18}$ W/cm$^2$. This is particularly preferred in case the phase modulated ultrashort laser pulse is used for generation of the x- and gamma-radiation via Compton scattering, since for higher intensities the quality of the scattering photon spectrum breaks down. This is most likely due to the fact that the amount of chirp of and the delay between the first laser pulse and the second laser pulse results in beating of the two, preferably Gaussian, pulse shapes of the first and second laser pulse and the resulting envelope of the phase modulated ultrashort laser pulse is not smooth anymore. It is further preferred, that the amount (value) of the positive chirp applied to the first laser pulse and amount (value) of the negative chirp applied to the second laser pulse is matched with (or in other words: adapted to) the envelope of the two-pulse. Thus, the steeper the slope of the envelope of the two-pulse, i.e. the shorter its pulse duration or higher its amplitude, the larger is the amount of the chirp applied to the first and second laser pulse.

This is particularly preferred for interactions with charged particles, since the ponderomotive force is stronger for steeper laser pulse envelops and the larger chirps of the first and second laser pulse ensure optimal compensation of the ponderomotive spectrum broadening.

For use of the phase modulated ultrashort laser pulse (two-pulse) for Compton scattering with electrons, the amount of chirp can be quantified by choosing at least two values of the instantaneous frequency $\omega_L(t)$ obtained by chirping the first or the second laser pulse at different times $t_i$ (i.e. for example $t_1$ and $t_2$) and by calculating the frequency of photons $\omega_i^\gamma$ scattered with an electron at the spectral position $\omega_L(t_i)$ ($\omega_L(t_1)$ and $\omega_L(t_2)$ in the example, i.e. with the respective instantaneous frequencies $\omega_1 = \omega_L(t_1)$ and $\omega_2 = \omega_L(t_2)$. The amount of chirp is then adjusted such that the frequency of the scattered photons $\omega_i^\gamma$ (i.e. $\omega_{1i}^\gamma$ and $\omega_2^\gamma$ ) is the same. In case of a linear chirp, the slope of the chirp (i.e. slope of the instantaneous frequency) can be determined in this way. This compensates quite exactly the ponderomotive effect in Compton scattering. In case of a non-linear chirp, the frequencies of photons $\omega_i^\gamma$ scattered with an electron at the spectral positions $\omega_L(t_i)$ can be calculated, and the functional dependency on the chirp can be adapted such that the frequencies of photons $\omega_i^\gamma$ are the same, in the sense of roughly the same (i.e. preferably within a range of about $\pm$ 20% or 10% of a mean or central frequencies $\omega_i^\gamma(t_i)$ of the scattered photons at spectral positions of the $\omega_L(t_i)$ electron).

Such matching of the amount of chirp to the envelope of the phase modulated ultrashort laser pulse is a very suited measure to optimize the phase modulation of the initial ultrashort laser pulse to obtain the two-pulse, as the resulting two-pulse then shows a spectral distribution $\omega_L(t_i)$ that minimizes the ponderomotive broading of the frequency $\omega_i^\gamma$ of the photons scattered by collision (scattering) of an electron with the phase modulated ultrashort laser pulse in Compton scattering.

In order to maximize the possible amount of photons in the phase modulated ultrashort laser pulse (two-pulse), the recombination of the first and second laser pulse to the two-pulse should be performed by a constructive interference. Thus, according to a preferred embodiment it is provided that the first laser pulse and the second laser pulse are coherently recombined.

This may be achieved in line with the invention by modulating the carrier-envelope-phase of the first laser pulse and/or the second laser pulse. The carrier-envelope-phase is the phase (displacement) between the carrier wave of the laser pulse and the position of the intensity envelope of the laser pulse, as indicated in Fig. 1b for the time dependence. The carrier-envelope-phase of the first and second laser pulse should correspond to each other in order to achieve constructive interference.

The carrier-envelope-phase modulation may be performed with a glass wedge in the propagation path of the first and/or second laser pulse. By passing the glass wedge, the phase of laser pulse is slightly changed depending on the active thickness of the glass at the position of passing. Accordingly, moving the glass wedge e.g. perpendicular to the direction of the pulse propagation changes the active thickness of the glass and allows for fine tuning of the relative phase of the first and second laser pulse.

In the experimental setup, the constructive interference may be achieved by surveying the intensity of the two-pulse when moving the glass wedge to find the maximum intensity. This can be achieved, for example, using the split-beam technique and spatial interferometry. In this case, the carrier envelope phase may be controlled for the first or the second laser pulse such that the interference of the first and second laser pulses is positive and the maximum number of photons is available. Thereby, also an unsmooth envelope of the phase modulated ultrashort laser pulse may be prevented, which could result from alternating constructive and destructive interference, if the carrier-envelope phase is not controlled. Usually, it is sufficient to control the carrier envelope phase of one laser pulse, since the relative phase between the first laser pulse and the second laser pulse determines the interference of both pulses. In this regard, it may be preferred to perform the steps of the present invention in the following order:

   a) apply a positive chirp to the first laser pulse and a negative chirp to the second laser pulse,
   b) introduce a delay between the first and the second laser pulse, and
   c) control the carrier envelope phase of the first laser pulse and/or the second laser pulse.

Although it is in principle possible, to perform the above mentioned steps in different order, the above mentioned preferred embodiment facilitates the optimization of the pulse shape of the phase modulated ultrashort laser pulse.

In order to survey the delay and chirp in experiments, one can perform spectral interferometry and analyze the spectral fringes, or perform FROG (frequency-resolved optical gating) analysis.

Assuming a Gaussian shape of the initial ultrashort laser pulse, the normalized spectral amplitude can be described by

$$\tilde{g}(\omega) = a_0 \frac{\omega_{L,0}}{\Delta\omega_L} \sqrt{\frac{\pi}{2}} e^{-\frac{(\omega - \omega_{L,0})^2}{2\Delta\omega_L^2}},$$

where

$a_0 = eA_0/mc^2$ is the normalized (dimensionless) amplitude of the electrical field (vector potential) of the initial ultrashort laser pulse with e and m the electron absolute charge and mass, respectively, $c$ is the speed of light in vacuum and $A_0$ the amplitude of the laser pulse vector potential in Gaussian CGS units,

$\omega_{L,0}$ is the central frequency of the laser pulse, and

$\Delta\omega_L$ is the bandwidth of the laser pulse spectrum.

Applying a relative phase (carrier-envelope phase), a time delay $\delta$ and an amount of chirp to the initial ultrashort laser pulse, can be described by adding a spectral phase $\tilde{\Phi}(\omega)$

$$\tilde{\Phi}(\omega) = B_0 + B_1 \frac{(\omega - \omega_{L,0})}{\Delta\omega_L} + \frac{1}{2} B_2 \frac{(\omega - \omega_{L,0})^2}{\Delta\omega_L^2}$$

to the laser pulse being a function of the frequency $\omega$, where the parameter $B_0$ is responsible for the relative phase (carrier-envelope-phase), the parameter $B_1$ is responsible for the time delay and the parameter $B_2$ is responsible for the amount of (linear) chirp. In case of non-linear chirp, the added spectral phase $\tilde{\Phi}(\omega)$ may contain further higher order terms $B_i$.

When

(i) starting with an initial (unchirped) ultrashort laser pulse with the spectral amplitude $\tilde{g}(\omega)$,
(ii) splitting it into a first and a second laser pulse using a beam splitter,
(iii) adding a spectral phase $\tilde{\Phi}(\omega)$ to the first laser pulse and the conjugate spectral phase $-\tilde{\Phi}(\omega)$ to the second laser pulse, using for example an optical setup with acousto-optical dispersive filters or diffraction gratings, and
(iv) coherently recombining the first and second laser pulse to the phase modulated ultrashort laser pulse (two-pulse) keeping the relative phase (carrier-envelope-phase) controlled using, for example, glass wedges,

the recombined two-pulse has the following spectrum

$$\tilde{a}(\omega) = \tilde{g}(\omega)\left(e^{i\tilde{\Phi}(\omega)} + e^{-\tilde{\Phi}(\omega)}\right).$$

The temporal structure of the two pulse can by analytically found by Fourier transform the spectrum $\tilde{a}(\omega)$. Accordingly, the normalized vector potential of the two-pulse can be written as $a(t)e^{i\tilde{\Phi}(t)}$, where $a(t)$ is the time-dependent amplitude, $\tilde{\Phi}(t)$ is the temporal phase of the two-pulse and $\omega_L(t) = d\tilde{\Phi}(t)/dt$ is the instantaneous frequency.

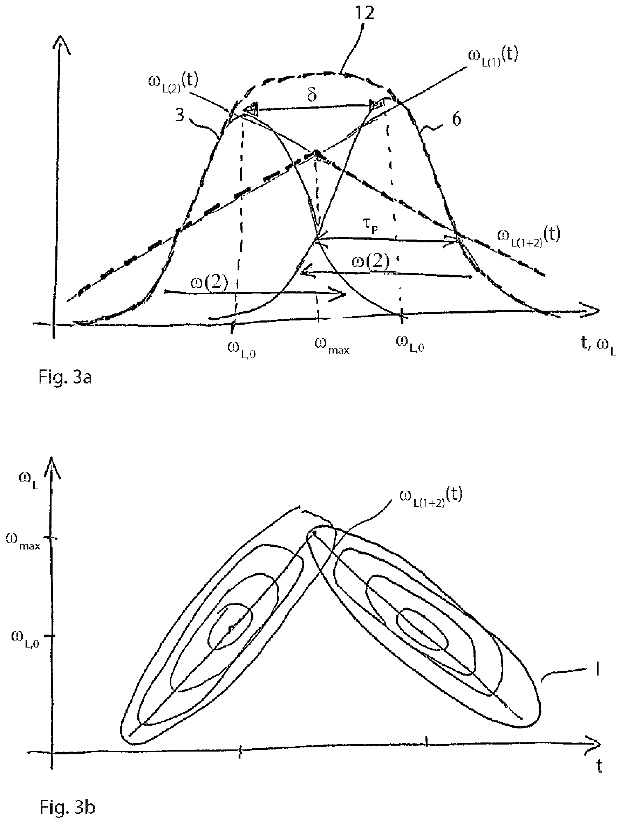

Generally, the time delay between the first and second pulse is $\delta = 2B_1/\Delta\omega_L$, and each pulse has a full-width at 1/$e$-duration $\tau_P = 2\sqrt{1 + B_2^2}/\Delta\omega_L$. This is shown in Figure 3a. The relative phase between the first and second pulse is

$$\Delta\Phi = 2B_0.$$

In order to find optimized values for the parameters $B_1$, $B_2$ and $B_0$ for compensating ponderomotive broadening in Compton scattering, one can use the following steps, which may be applied separately from each other, but are preferably used in combination in order to achieve the best results.

First, the delay $\delta$ between the first and the second laser pulse should be preferably equal to the duration $\tau_P$ of the first and second laser pulse.

Second, the interference to the two pulses is preferably constructive such that the resulting laser pulse contains the maximum possible amount of photons. This may be achieved by controlling the relative phase between the first and second laser pulse or in other words by controlling the carrier-envelope-phase of the first and/or second laser pulse.

Finally, it is preferred to match the slope of the chirp to the change of the envelope. This matching can be achieved by selecting two values of the instantaneous frequency for the phase modulated ultrashort laser pulse: one frequency at the center of the first or second laser pulse and another frequency at the middle of the phase modulated ultrashort laser pulse. The instantaneous frequency at the center of the first or second laser pulse is equal to the central frequency of the initial ultrashort laser pulse, whereas the instantaneous frequency at the center of phase modulated ultrashort laser pulse is equal to the maximum value of the instantaneous frequency. Moreover, the frequency of the scattered photons at both instantaneous frequencies as selected above should be the same, if the ideal pulse shape is met.

Taken the above steps into account, it is particularly preferred that the parameters $B_1$, $B_2$ and $B_0$ are controlled such that:

$$B_1 = \chi\sqrt{1 + B_2^2}, \qquad\qquad (1)$$

$$B_2 = -\frac{a_0^2}{4}\frac{\omega_{L,0}}{\Delta\omega_L}\left(4e^{-\chi^2} - 1 - \chi\frac{\Delta\omega_L}{\omega_{L,0}}\right), \qquad\qquad (2)$$

$$B_0 = \pi n + \frac{B_1^2 B_2}{2(1+B_2^2)} - \frac{1}{4}\arctan B_2, \qquad\qquad (3)$$

are fulfilled, wherein $n$ is a normal number, $a_0$ is the laser field amplitude of the first laser pulse and the second laser pulse and $\chi$ is a proportionality factor, usually in the range of 0.8 to 1.2, preferably in the range of 0.9 to 1.1.

The specific values for $B_1$, $B_2$ and $B_0$ can be found by numerical solutions for a given initial ultrashort laser pulse having specific values for $a_0$, $\omega_{L,0}$ and $\Delta\omega$. The above values of $B_1$, $B_2$ and $B_0$ were found to resemble the optimal parameters for the laser pulse shape of the phase modulated ultrashort laser pulse, in particular if used in Compton scattering processes.

In order to find the optimal parameters, a feedback loop may be used, which comprises a control unit adapted to control the respective parameters based on a measured signal, e.g. the intensity of the scattered photon spectrum. The parameters $B_1$, $B_2$ and $B_0$ may also be summarized in terms of vector **B** = ($B_0$, $B_1$, $B_2$).

In a preferred embodiment or use of the present invention, the phase modulated ultrashort laser pulse interacts with charged particles, preferably electrons. In other words, it is preferred that the phase modulated ultrashort laser pulse is directed onto charged particles, such that these particles are accelerated by the electric field of the phase modulated ultrashort laser pulse, which allows compensation of ponderomotive effects observed for such light-matter interactions.

In a further preferred embodiment, the phase modulated ultrashort laser pulse may be used for generation of high energy photons, preferably x- and gamma-rays, preferably by Compton scattering obtained via interaction with, preferably relativistic free, electrons. In this case, ponderomotive broadening usually observed in Compton scattering processes can be minimized. For the thus generated radiation, the present invention allows a reduced bandwidth for the scattered photon spectrum for a given peak intensity. Or, in case the spectral bandwidth is fixed, higher peak intensities and thus brighter and more brilliant spectra may be obtained.

The invention also refers to a device for phase modulating an ultrashort laser pulse according to claim 10 comprising a beam splitter for splitting the initial ultrashort laser pulse into a first laser pulse and a second laser pulse. Further, a first optical path for the first laser pulse and a second optical path for the second laser pulse are provided, wherein the second optical path is different from the first optical path. The first and the second optical paths have different path lengths introducing thus a time delay between the first laser pulse and the second laser pulse. At least one of the optical paths has a means for tuning the path length of the optical path for adjusting the time delay. At least one spectral phase modulator is provided in the first optical path adapted to apply a positive chirp to the first laser pulse in line with the method disclosed before, and at least one spectral phase modulator is provided in the second optical path adapted to apply a negative chirp to the second laser pulse. The device further comprises a beam splitter for recombining the first laser pulse and the second laser pulse to form the phase modulated ultrashort laser pulse (two-pulse). The device components are in line with the invention adapted and adjusted to perform the method described before or parts thereof.

In a preferred embodiment, the means for tuning the path length of the optical path may comprise a reflective mirror moveable in the direction of beam of the laser pulse reflected in the mirror. The mirror may be, preferably a 100% reflective mirror. Displacement of the mirror may be performed by a control device dependent on a measured time delay between the first and the second laser pulse.

The spectral phase modulator in each optical path of a preferred device may further comprise a spatial light modulator, a prism- or grating-based pulse shaper, chirped mirrors, a LCD-mask and/or a dazzler for adjusting a positive or negative chirp, preferably a positive or negative linear chirp, to the first and second laser pulses. Adjustment of the spectral phase modulator may be performed by a control device dependent on a determined envelope of the two pulse and determining the frequency of a Compton scattered photon based on the instantaneous frequency as described before. It might also be possible to use one single spectral phase modulator in both, the first and the second optical paths. It is, however, preferred to have two different spectral phase modulators, one fort the first and the other for the second laser pulse.

The device may further comprise a carrier-envelope-phase controller at least in one of the first or second optical paths. With the carrier-envelope phase controller, a coherent recombination of the first and second laser pulse can be achieved. To this aim, the carrier-envelope phase controller may be adapted to modulate the phase of at least one of the first or second laser pulses such that the recombined first and second laser pulses show a constructive interference. The carrier-envelope phase controller may be, for example, a glass wedge as explained above. Adjustment of the carrier-envelope phase controller may be performed by a control device dependent on a determined intensity of the two pulse to maximize this intensity, e.g. based on a feed-back loop control.

For creating the phase modulated ultrashort laser pulse (two-pulse), the proposed device can further comprise a laser pulse source emitting an initial ultrashort laser pulse having e.g. a pulse duration of less than 100 femtoseconds and/or any of the properties of the initial laser pulse as described above. For performing scattering of the two-pulse with a charged particle, the proposed device can further comprise a collision chamber for colliding phase modulated ultrashort laser pulses with charged particles, e.g. relativistic electrons. This may be used for Compton Scattering processes as described above. In line with this aspect of the invention, a system for producing high energy photons according to the method described above or parts thereof, and in particular according to any one of the claims 1 to 9, is provided. According to a preferred embodiment, a system for performing Compton scattering between the phase modulated ultrashort laser pulses and electrons as charged particles is proposed in line with the invention. Accordingly, the invention also relates o a method and a device for performing Compton scattering between accelerated electrons and ultrashort laser pulses, wherein the ultrashort laser pulses have been created using the method as described before.

According to a preferred embodiment of the invention, the device may comprise a spectrum analyzer adapted to determine physical properties of the first laser pulse, the second laser pulse and/or the phase modulated ultrashort laser pulse and a control unit adapted to adjust at least one of the spectral phase modulator, the means for tuning the path length of the optical path and/or the carrier-envelope-phase controller in line with the method described before or parts thereof. The spectrum analyzer and the controller may be integrated into a processor device with suited detection and computation means, the processor being adapted by program code means to perform the method as described before or parts thereof.

Laser sources suitable for the present invention are commercially available and usually include a solid state seed laser and a chirped pulse amplifier. In order to introduce the delay between the first and the second laser pulse the means for introducing such a delay may elongate or shorten the optical path of the respective laser pulse. For example, the optical path of the first laser pulse may be shortened in order to introduce the delay between the first and the second laser pulse. Alternatively or in addition thereto, the optical path of the second laser pulse may be elongated in order to introduce the delay between the first and the second laser pulse. In order to modify the length of the respective optical paths, positioning tables, preferably with mirrors, may be used.

Although the most straightforward set-up provides one spectral phase modulator for the first laser pulse and another for the second laser pulse, one example of an embodiment only using one spectral phase modulator includes a prism-based pulse shaper usually including two or four prisms. For such a spectral phase modulator, the sign of the chirp depends on the incidence angle. In case the first laser pulse is directed in one direction towards said spectral phase modulator, the second laser pulse may be directed in exactly the opposite direction, and thus the chirp of the laser pulses will be exactly opposite. Thus, a device only including one spectral phase modulator for both, the first and the second optical path, is feasible.

In general, possible optical paths of the device may be based on the known set-up of a Michelson interferometer, in which for the beam splitting of the initial ultrashort laser pulse and for the recombination of the first and second laser pulses a single beam splitter is used. However, in line with the invention, any suited means for recombining the first and second laser pulses include any optical path array, which spatially and temporally overlaps both the first and second laser pulse. This is summarized with the term "beam splitter" which - in reverse operation - is recombining two beams. Whereas the spatial overlap only requires the beam path of the first laser pulse to be superimposed with the beam path of the second laser pulse and vice versa, an at least partial temporal overlap of both pulses requires both laser pulses located in the same place at the same time, namely within the duration of the respective laser pulses.

It may be preferred to observe the two-pulse by a spectrum analyzer and/or the photon spectrum generated by Compton scattering for optimizing the parameters discussed above in accordance to the described method. This may be done by a state of the art feedback loop.

For optimizing the constructive interference of the first and second laser pulse in the recombined two-pulse, e.g. the intensity of the two-pulse and/or of the Compton scattered photon spectrum can be determined and maximized. For adjusting the time delay of the first and second laser pulse, a commercially available spectrum analyzer, e.g. utilizing frequency-resolved optical gating

(FROG), may be used. Such a commercially available spectrum analyzer may be arranged to determine the intensity, spectral distribution and/or time distribution of the laser pulses and the delay between the first and second laser pulse. Thus, the above discussed parameters can be adjusted based on measurements of the spectrum analyzer. Further, the parameters may be optimized by observing the intensity and/or spectral distribution of the scattered photon spectrum in order to maximize intensity and minimize the spectral bandwidth of the observed scattered photon spectrum.

Further advantages, features and possible applications of the present invention can also be taken from the following description of an exemplary embodiment and the drawings. All features described and/or illustrated form the subject-matter of the present invention per se or in any combination, also independent of their inclusion in the claims or their back-references.

Figure 1    schematically shows the spectral intensity distribution (Figure 1a) and the time intensity distribution (Figure 1 b) for an unchirped ultrashort laser pulse;

Figure 2    schematically shows a three-dimensional time-spectral intensity distribution (spectrogram) with higher intensity indicated by smaller closed curves for an unchirped laser pulse (Figure 2a, summarizing Figures 1 a and 1 b in one three-dimensional plot), for a positively chirped laser pulse (Figure 2b) and for a negatively chirped laser pulse (Figure 2c);

Figure 3    schematically shows for the phase modulated ultrashort laser pulse (two-pulse) according to an embodiment of the invention the intensity distribution (Figure 3a) and the three-dimensional time-spectral intensity distribution (Figure 3b);

Figure 4    schematically depicts an embodiment of the device according to the invention with an experimental set up suitable for performing the proposed method;

Figure 5    shows the time dependent amplitude $a(t)$ of the laser pulse as a function of time of the initial laser pulse without modulation, i.e. with the parameter vector B = 0, (dashed line), of the optimally chirped two-pulse (including its waveform) and an equivalent unchirped Gaussian pulse;

Figure 6    shows on-axis Compton scattered photon spectra obtained by interaction with the initial unchirped laser pulse (short dashed line), an equivalent unchirped Gaussian pulse created by an overlap of equivalent laser pulses with same intensity, pulse duration and delay, but without any chirp (solid line) and the chirped two-pulse (long dashed line) as a function of $\omega_\gamma/\omega_{L,0}$;

Figure 7    shows the optimal parameter vector $\mathbf{B} = (B_0, B_1, B_2)$ as well as the spectral bandwidth of the scattered photon spectrum $\Delta\omega/\omega_{L,0}$ as function of the laser field amplitude $a_0$; and

Figure 8    shows the peak of the scattered photon spectrum for an unchirped laser pulse, an optimally phase modulated (chirped) ultrashort laser pulse in accordance to the present invention and the equivalent unchirped Gaussian laser pulse.

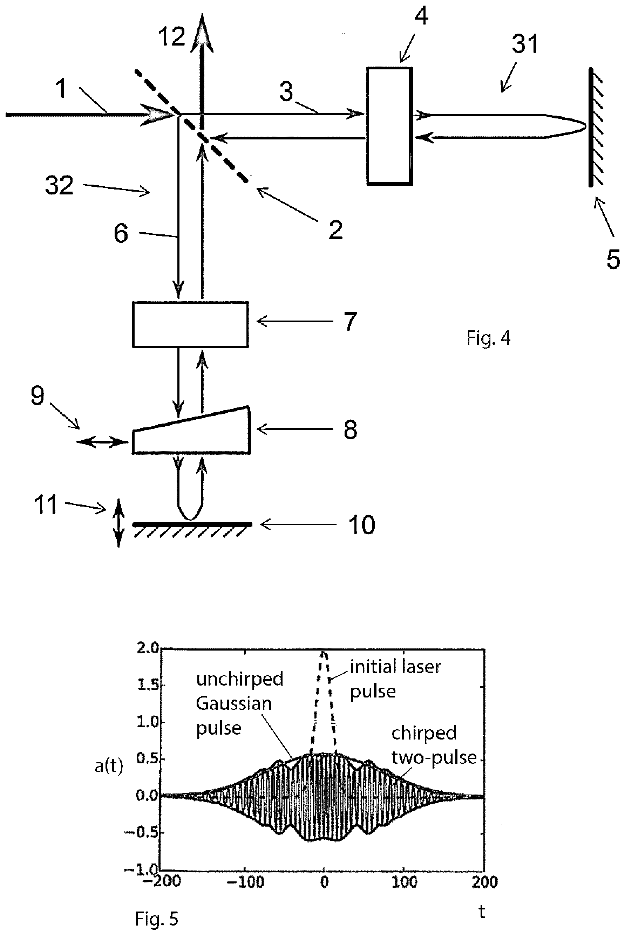

An embodiment of the device according to the invention is shown in Figure 4 depicting the essential experimental setup for performing the method in all variants already described.

An initial ultrashort laser pulse 1 is directed to beam splitter 2 and is thus split into a first laser pulse 3 and a second laser pulse 6. In the example shown, the first laser pulse 3 is transmitted along a first optical path 31 through beam splitter 2 and a positive chirp is applied to the first laser pulse 3 by a spectral phase modulator 4. Typical examples for such a spectral phase modulator 4 include a pair of prism or gratings, chirped mirrors or a spatial light modulator (SLM). Subsequently, the (chirped) first laser pulse 3 is directed to a fixed mirror 5, reflected therefrom and redirected to the spectral phase modulator 4. The mirror 5 may in an alternative example also be movable in a direction parallel to the optical path 31 of the first laser pulse 3, such that the length of the beam path of the first laser pulse 3 may be controlled, which can influence the delay between the first laser pulse 3 and the second laser pulse 6.

The beam path 31 of the first laser pulse 3 as described before is particularly preferred when using chirped mirrors as spectral phase modulator 4, since the chirp applied to the first laser pulse 3 is increased with the second passing of the first laser pulse 3 through spectral phase modulator 4 after perpendicular reflection of the first laser pulse 3 at the mirror 5. Of course, depending on the specific spectral phase modulator 4 used, the optical path 31 of the first laser pulse 3 may be set up such that phase modulator 4 is only passed once.

The second laser pulse 6 is reflected by beam splitter 2, said second laser pulse 6 being directed perpendicular to the first laser pulse 3. In this example, the second laser pulse 6 in the second optical path 32 passes a spectral phase modulator 7 applying a negative chirp. The spectral phase modulator 7 may be similar to the spectral phase modulator 4, applying a chirp to second laser pulse 6 being the conjugate chirp to the chirp applied to the first laser pulse 3.

Subsequently in the optical path 32, the carrier-envelope-phase of the second laser pulse 6 is modulated (shifted) using a glass wedge as an example for a carrier-envelope-phase controller 8. Depending on the length of the optical path 32 through glass wedge 8, the carrier-envelope-phase is shifted relative to the envelope of the second laser pulse 6 as described before. By moving glass wedge 8 in a direction perpendicular to the optical path 32 (illustrated by arrow 9 in Figure 4), the length of the optical path through glass wedge 8 is changed and, thereby, the carrier-envelope-phase of the second laser pulse 6 is shifted.

For introducing a defined time delay between the first and the second laser pulse 3 and 6, a mirror 10 is provided in the optical path 32, the mirror 10 being movable in the direction of the optical path 32, as illustrated by arrow 11. The second laser pulse is reflected by the mirror 10 to pass after the reflection again the glass wedge 8 and the phase modulator 7 for a second time after.

By disposing the mirror 10 along the direction of arrow 11, the total length of the optical path 32 is elongated or shortened, depending on the direction of movement. Accordingly, the traveling time of the second laser pulse 6 is changing relative to the traveling time of the first laser pulse 3. Accordingly, the time delay between the first and second laser pulse 3 and 6 is adjusted by mirror 10.

As discussed for the first optical path 31, also in the second optical path 32 the glass wedge 8 and the spectral phase modulator 7 may be passed only once by the second laser pulse 6 depending on specific requirements and the specific spectral phase modulator used.

Generally, variations to the optical paths 31, 32 may be used by the one skilled in the art according to the specific apparatus setup without departing form the invention.

The (chirped) first and second laser pulses 3, 6 are finally recombined by spatially and temporally overlapping both pulses 3, 6 with the time delay $\delta$ in the beam splitter 2 to form the phase modulated ultrashort laser pulse 12 (also designated as two-pulse in entire description).

The experimental set-up shown in figure 4 is based on a Michelson interferometer optical pathing. The resulting phase modulated ultrashort laser pulse 12 may be characterized using methods known in the art, such as frequency resolved optical gating (FROG), and is preferably used for Compton scattering in order to produce x- and gamma rays. The respective spectrum analyzer, control unit, laser and collision chamber as components of the claimed device are known in the art and not displayed in the drawings.

The typical pulse shape (envelope) of the two-pulse (phase modulated ultrashort laser pulse 12) obtained by the method and device described herein, is shown in Figure 3a. The intensities $I$ of the first laser pulse 3 (as observable in the first optical path 31 after chirping), of the second laser pulse 6 (as observable in the second optical path 32 after chirping) and of the phase modulated ultrashort laser pulse 12 are shown as a function of time t in arbitrary units.

Whereas the envelopes of the first laser pulse 3 and second laser pulse 6 are shown in solid lines, the resulting envelope of the phase modulated ultrashort laser pulse 12 (two-pulse) is shown as dotted line. In this preferred embodiment, the pulse duration $\tau_P$ of the second laser pulse 6 is equal to the pulse duration $\tau_P$ of the first laser pulse 3 (not sketched in for clarity reasons). Further, the time delay $\delta$ between both the first and second laser pulse 3, 6 corresponds to the pulse duration $\tau_P$ of the second laser pulse 6, as already described in detail before.

After chirping, the frequencies $\omega(1)$ of the first laser pulse 3 (positive chirp) are increasing with time (as indicated with the arrow $\omega(1)$) and the frequencies $\omega(2)$ of the first laser pulse 6 (positive chirp) are decreasing with time (as indicated with the arrow $\omega(2)$).

The instantaneous frequencies $\omega_{L(1)}(t)$ and $\omega_{L(2)}(t)$ of the first and second laser pulse 3, 6 are indicated with normal lines (having the unit "frequency $\omega_L$" on the y-axis instead of the intensity $I$).

Furthermore, the instantaneous frequency $\omega_{L(1+2)}(t)$ of the phase modulated ultrashort laser pulse 12 is shown as dashed line. Since the first laser pulse 3 has a positive chirp, the instantaneous frequency $\omega_{L(1+2)}(t)$ of the phase modulated ultrashort laser pulse is increasing with time in the region in which the intensity, and thus the electric field, of the first laser pulse 3 is dominant. As soon as the first laser pulse 3 and the second laser pulse 6 temporally overlap and interfere, the positive chirp of the first laser pulse 3 is challenged by the negative chirp of the second laser pulse 6, whose influence on the instantaneous frequency $\omega_{L(1+2)}(t)$ of the phase modulated ultrashort laser pulse 12 is increasing with the increasing amplitude of the electric field of the second laser pulse 6.

Thus, a maximum instantaneous frequency $\omega_{max}$ of the phase modulated ultrashort laser pulse 12 is obtained at the time, in which a constructive interference of the first and second laser pulses 3 and 6 is maximized. With increasing intensity of the second laser pulse 6 and decreasing intensity of the first laser pulse 3, the negatively chirped second laser pulse 6 determines the instantaneous frequency $\omega_{L(1+2)}(t)$ of the phase modulated ultrashort laser pulse 12, which is, therefore, decreasing over time after its maximum $\omega_{max}$.

This behavior is also evident form the spectrogram depicted in Figure 3b showing the intensity $I$ both, as a function of time t and frequency $\omega_L$.

The instantaneous frequency $\omega_{L(1)}(t)$, $\omega_{L(2)}(t)$ shown in Figure 3 is basically linear, due to linear chirps applied to the first and second laser pulses 3, 6. More complex chirps and instantaneous frequency progressions are feasible.

Figure 3a also shows the central frequency $\omega_{L,0}$ of the first and second laser pulse 3, 6, which basically corresponds to the central frequency of initial ultrashort laser pulse 1. Whereas the frequency $\omega_{L,0}$ of the first and second laser pulses 3, 6 corresponds to the most intense frequency for the split pulses 3, 6, the intensity maximum of the phase modulated ultrashort laser pulse 12 (two-pulse) is obtained at the maximum frequency $\omega_{max}$. Furthermore, it becomes apparent that the instantaneous frequency distribution $\omega_{L(1+2)}(t)$ of the phase modulated ultrashort laser pulse 12 is symmetrical with respect to the maximum instantaneous frequency $\omega_{max}$, such that each instantaneous frequency $\omega_{L(1+2)}(t_i)$, except the frequency $\omega_{max}$ is present at two different times $t_i$.

A comparison of the time dependent wave form for different pulse types is shown in Figure 5 depicting the time-dependent amplitude $a(t)$ as a function of time. The dashed line represents the initial (unchirped) ultrashort laser pulse having the narrowest pulse form. For an optimally chirped two-pulse, the pulse form is depicted including the wave form. Due to the phase modulation, the duration of the two-pulse is many times longer than the duration of the initial laser pulse, while the maximum amplitude $a(t_0)$ is much smaller. The third pulse form is represented by an equivalent unchirped Gaussian pulse having a duration comparable to the duration of the two-pulse.

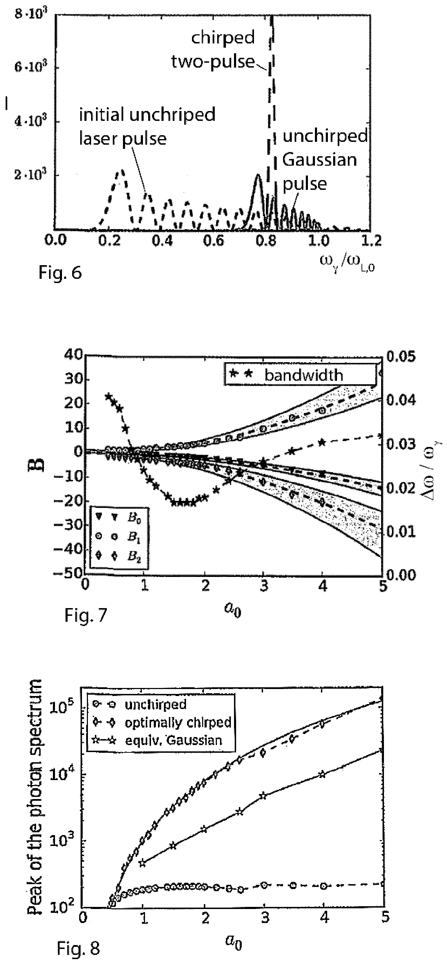

Interesting is a comparison of the spectra of Compton scattered photons with a laser pulse as described before. Figure 6 shows photon spectrum for photons scattered with an electron in Compton scattering with a scattering angle $\vartheta = 0$ (on-axis) as a function of the normalized frequency $\omega_\gamma/\omega_{L,0}$. It turns out that the initial unchirped laser pulse creates the broadest photon spectrum due to ponderomotive spectrum broadening which is strongest for the high intensity photons. The unchirped equivalent Gaussian pulse, i.e. a Gaussian pulse with stretched duration and reduced amplitude (as an unchirped approximation of the "two-pulse"), shows a narrower spectrum due to the lower peak intensity of the photons and the thus reduced ponderomotive effect. A very sharp (narrow) spectrum of scattered photons is obtained by using optimum parameters $\mathbf{B} = (B_0, B_1, B_2)$ in line with the method proposed with the invention.

Figure 7 shows an example of optimum parameters for the vector $\mathbf{B} = (B_0, B_1, B_2)$ for different amplitudes $a_0$ of the laser field for a given bandwidth $\Delta\omega$ and central frequency $\omega_{L,0}$ of the initial ultrashort laser pulse 1. The parameters $B_0$ (triangles), $B_1$ (circles) and $B_2$ (diamonds) lead to the narrowest on-axis scattered photon spectrum obtained by a simulation. The dashed lines are based on the parameters $\mathbf{B} = (B_0, B_1, B_2)$ as described in claim 9 with $\chi = 0.96$. The respective shaded areas show the range of the parameters for setting $\chi$ in the range $0.9 < \chi < 1$.

Also shown in Figure 7 (right y-axis) is the bandwidth $\Delta\omega/\omega_\gamma$ of the photon spectrum obtained by the Compton scattering as a function of the normalized amplitude $a_0$ and being generated by a corresponding optimized phase modulated ultrashort laser pulse with optimized parameters $\mathbf{B} = (B_0, B_1, B_2)$ in accordance with the invention.

Finally, Figure 8 depicts the peak of the on-axis scattered photon spectrum as a function of the normalized laser field amplitude $a_0$ for an unchirped laser pulse, an optimally chirped phase modulated ultrashort laser pulse (two-pulse) and an equivalent unchirped Gaussian pulse. It is apparent that the phase modulated ultrashort laser pulse being optimally chirped in accordance to the present invention generates the highest peak intensities. In comparison to a single unchirped laser pulse, the present invention can generate scattered Compton radiation being several orders of magnitude brighter. In comparison to an equivalent Gaussian pulse obtained by overlapping the first and second laser pulses with the same delay and carrier envelope phase, but without application of any chirp, still a significant effect is observed due to the reduction of intensity of the laser pulse scattering with the electron.

Thus, the present invention allows very effective compensation of ponderomotive effects and ponderomotive spectrum broadening observed in Compton scattering with ultrashort laser pulses.

**Reference numerals**

1    initial ultrashort laser pulse
2    beam splitter
3    first laser pulse
4    spectral phase modulator

5    fixed mirror
6    second laser pulse
7    spectral phase modulator
8    carrier-envelope-phase controller, e.g. glass wedge
9    arrow
10   means for tuning the path length of the optical path, e.g. movable mirror
11   arrow
12   phase modulated ultrashort laser pulse
31   first optical path
32   second optical path

$\tau_P$      duration of laser pulse
$\Delta\omega_L$    bandwidth of laser pulse
$\omega_L(t)$   instantaneous frequency of chirped laser pulse
$\omega_{L,0}$  central frequency of laser pulse
$\delta$      time delay between first and second laser pulse

## Claims

**1.** Method for creating a phase modulated ultrashort laser pulse (12), comprising the following steps:

- an initial ultrashort laser pulse (1) is split into a first laser pulse (3) and a second laser pulse (6),
- a time delay ($\delta$) is introduced between the first and the second laser pulse (3, 6),
- a positive chirp is applied to the first laser pulse (3) and a negative chirp is applied to the second laser pulse (6) obtaining an instantaneous frequency ($\omega_L$(t)) for the first and second laser pulse (3) and (6), and
- the first laser pulse (3) and the second laser pulse (6) are recombined to form the phase modulated ultrashort laser pulse (12).

**2.** Method according to claim 1, **characterized in that** a linear chirp is applied to the first laser pulse (3) and the second laser pulse (6), wherein the positive chirp of the first laser pulse (3) is opposite to the negative chirp of the second laser pulse (6).

**3.** Method according to claim 1 or 2, **characterized in that** a pulse duration ($\tau_P$) of the first laser pulse (3) and the second laser pulse (6) is the same.

**4.** Method according to any of the preceding claims, **characterized in that** the time delay ($\delta$) between the first laser pulse (3) and the second laser pulse (6) is the same as the pulse duration ($\tau_P$) of the first laser pulse (3) and/or the second laser pulse (6).

**5.** Method according to any one of the preceding claims, **characterized in that** the amount of the positive chirp applied to the first laser pulse (3) and the amount of the negative chirp applied to the second laser pulse (6) is matched to the envelope the phase modulated ultrashort laser pulse (12).

**6.** Method according to any of the preceding claims, **characterized in that** the amount of chirp is quantified by

- choosing at least two values of the instantaneous frequency ($\omega_L$(t)) obtained by chirping the first or the second laser pulse (3, 6) at different times ($t_i$);

- calculating the frequencies of photons $\omega_i^\gamma$ scattered with an electron and the instantaneous frequency (($\omega_L(t_i)$)) of the phase modulated laser pulse (12) at the times ($t_i$); and

- adjusting the amount of chirp such that the frequency of the scattered photons $\omega_i^\gamma$ is the same.

**7.** Method according to one of the preceding claims, **characterized in that** the first laser pulse (3) and the second laser pulse (6) are coherently recombined.

**8.** Method according to claim 7, **characterized in that** the relative phase of the first laser pulse (3) and second laser pulse (6) are controlled by modulating the carrier-envelope-phase of the first laser pulse (3) and/or the second laser pulse (6).

9. Method according to one of the preceding claims, **characterized in that** the chirp, time delay ($\delta$) and relative phase applied to the first laser pulse (3) and the second laser pulse (6) is described by adding a spectral phase ($\widetilde{\Phi}(\omega)$) to the first laser pulse (3) and the conjugated spectral phase ($-\widetilde{\Phi}(\omega)$) to the second laser pulse (6), the spectral phase being parameterized as

$$\widetilde{\Phi}(\omega) = B_0 + B_1 \frac{(\omega - \omega_{L,0})}{\Delta\omega_L} + \frac{1}{2} B_2 \frac{(\omega - \omega_{L,0})^2}{\Delta\omega_L^2}$$

with the parameters $B_1$, $B_2$ and $B_0$ being:

$$B_1 = \chi \sqrt{1 + B_2^2},$$

$$B_2 = -\frac{a_0^2}{4} \frac{\omega_{L,0}}{\Delta\omega_L} \left(4e^{-\chi^2} - 1 - \chi \frac{\Delta\omega_L}{\omega_{L,0}}\right),$$

$$B_0 = \pi n + \frac{B_1^2 B_2}{2(1+B_2^2)} - \frac{1}{4} \arctan B_2,$$

where

n is a natural number,
$\chi$ is controlled in the range of 0.8 to 1.2,
$a_0 = eA_0/mc^2$ is the normalized (dimensionless) amplitude of the electrical field (vector potential) of the initial ultrashort laser (1) pulse with e and m the electron absolute charge and mass, respectively, c the speed of light in vaccum and $A_0$ the amplitude of the laser pulse vector potential in Gaussian CGS units,
$\Delta\omega_L$ is the bandwidth of the laser pulse,
$\omega_{L,0}$ is the central frequency of the laser pulse, and
$\omega$ is the current frequency.

10. Device for phase modulating an ultrashort laser pulse (12), the device comprising

- a beam splitter (2) for splitting the initial ultrashort laser pulse (1) into a first laser pulse (3) and a second laser pulse (6);
- a first optical path (31) for the first laser pulse (3) and a second optical path (32) for the second laser pulse (6), the first and the second optical paths (31, 32) having different path lengths introducing thus a time delay ($\delta$) between the first laser pulse (3) and the second laser pulse (6), wherein at least one of the optical paths (31, 32) has a means for tuning the path length of the optical path (10);
- at least one spectral phase modulator (4) in the first optical path (31) adapted to apply a positive chirp to the first laser pulse (3);
- at least one spectral phase modulator (7) in the second optical path (32) adapted to apply a negative chirp to the second laser pulse (6),
- a beam splitter (2) for recombining the first laser pulse (3) and the second laser pulse (6) to form the phase modulated ultrashort laser pulse (12).

11. Device according to claim 10, **characterized in that** the means for tuning the path length of the optical path comprises a reflective mirror (10) moveable in the direction of beam of the laser pulse reflected in the mirror (10).

12. Device according to claim 10 or 11, **characterized in that** the spectral phase modulator (4, 7) comprises a spatial light modulator, a prism- or grating-based pulse shaper, chirped mirrors, a LCD-mask and/or a dazzler.

13. Device according to any of the claims 10 to 12, **characterized in that** the device comprises a carrier-envelope phase controller (8) at least in one of the first or second optical paths (31, 32).

14. Device according to any of the claims 10 to 13, **characterized in that** the device comprises a laser pulse source emitting an initial ultrashort laser pulse (1) and/or a collision chamber for colliding the phase modulated ultrashort laser pulse (12) with charged particles.

15. Device according to any of the claims 10 to 14, **characterized in that** the device comprises a spectrum analyzer adapted to determine physical properties of the first laser pulse (3), the second laser pulse (6) and/or the phase modulated ultrashort laser pulse (12), and a control unit adapted adjust at least one of the spectral phase modulator (4, 7), the means for tuning the path length of the optical path (10) and/or the carrier-envelope phase controller (8) in line with the method proposed according to any one of the claims 1 to 9.

Fig. 1a

Fig. 1b

Fig. 2a

Fig. 2b

Fig. 2c

Fig. 3a

Fig. 3b

Fig. 4

Fig. 5

Fig. 6

Fig. 7

Fig. 8

Europäisches
Patentamt

European
Patent Office

Office européen
des brevets

# EUROPEAN SEARCH REPORT

**Application Number**

EP 17 16 3851

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 103 605 249 A (UNIV HUAZHONG SCIENCE TECH) 26 February 2014 (2014-02-26) | 1,8,10, 11,13,14 | INV. H01S3/00 |
| A | * paragraphs [0002] - [0009], [0027] - [0029]; figure 1 * | 2-7,9, 12,15 | ADD. H05G2/00 H01S3/11 |
| X | CN 1 187 913 C (UNIV SHANGHAI JIAOTONG [CN]) 2 February 2005 (2005-02-02) | 1-4,8, 10,13,14 | |
| A | * page 7; figures 1a,2 * | 5-7,9, 11,12,15 | |
| X | US 2010/271635 A1 (RESCH KEVIN [CA]) 28 October 2010 (2010-10-28) | 1,7,8, 10-15 | |
| A | * paragraphs [0030] - [0031], [0039] - [0043]; figures 2a,2b,10 * | 2-6,9 | |
| A | GHEBREGZIABHER I ET AL: "Spectral bandwidth reduction of Thomson scattered light by pulse chirping", PHYSICAL REVIEW SPECIAL TOPICS - ACCELERATORS AND BEAMS AMERICAN PHYSICAL SOCIETY USA, vol. 16, no. 3, March 2013 (2013-03), XP002774661, ISSN: 1098-4402 * paragraphs [0001], [0004]; figures 5,6,7 * | 1-15 | |

TECHNICAL FIELDS SEARCHED (IPC)

G02F
H01S
H05G

The present search report has been drawn up for all claims

| Place of search | Date of completion of the search | Examiner |
|---|---|---|
| Munich | 19 October 2017 | Cortona, Anna |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 16 3851

This annex lists the patent family members relating to the patent documents cited in the above-mentioned European search report.
The members are as contained in the European Patent Office EDP file on
The European Patent Office is in no way liable for these particulars which are merely given for the purpose of information.

19-10-2017

| Patent document cited in search report | | Publication date | Patent family member(s) | | Publication date |
|---|---|---|---|---|---|
| CN 103605249 | A | 26-02-2014 | NONE | | |
| CN 1187913 | C | 02-02-2005 | NONE | | |
| US 2010271635 | A1 | 28-10-2010 | CA | 2710296 A1 | 02-07-2009 |
| | | | EP | 2232232 A1 | 29-09-2010 |
| | | | US | 2010271635 A1 | 28-10-2010 |
| | | | WO | 2009079759 A1 | 02-07-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Beam-shape effects in nonlinear Compton and Thomson scattering. *Physical Review A,* 2010, vol. 81, 022125
- Quasi-monoenergetic femtosecond photon sources from Thomson Scattering using laser plasma accelerators and plasma channels. *J. Phys. B: At. Mol. Opt. Phys.,* 2014, vol. 47, 234013
- Narrowband inverse Compton scattering x-ray sources at high laser intensities. *Physical Review,* 2015, vol. A 91, 033402